# EUROPÄISCHE PATENTSCHRIFT

(11) **EP 2 684 253 B1**
(45) Veröffentlichungstag und Bekanntmachung des Hinweises auf die Patenterteilung: **22.04.2015**
(21) Anmeldenummer: 12720401.4
(22) Anmeldetag: 22.02.2012
(51) Int. Cl.: H01R 9/03

(54) **ANSCHLUSSVORRICHTUNG UND ANSCHLUSSVERFAHREN FÜR HOCHFREQUENTE DIGITALSIGNALE**
DEVICE AND PROCESS FOR CONNECTING HIGH FREQUENZY DIGITAL SIGNALS
DISPOSITIF ET PROCÉDÉ DE CONNEXION POUR SIGNAUX DIGITAUX À HAUTE FRÉQUENCE

(30) Priorität: 11.03.2011 DE 102011001225
(43) Veröffentlichungstag der Anmeldung: 15.01.2014
(73) Patentinhaber: HARTING Electronics GmbH, 32339 Espelkamp (DE)
(72) Erfinder: HAVERMANN, Gert, 49134 Wallenhorst (DE)
(86) Internationale Anmeldenummer: PCT/DE2012/100044
(87) Internationale Veröffentlichungsnummer: WO 2012/122974

(56) Entgegenhaltungen:
- WO-A1-2004/062046
- US-A1- 2003 064 616
- US-A1- 2010 294 530

## Beschreibung

Die Erfindung betrifft eine Anordnung, bestehend aus einer Anschlussvorrichtung für hochfrequente Datensignale und mindestens einer zum Anschluss daran vorgesehenden Datenleitung, insbesondere einem sogenannten" Twinax"-Kabel, wobei die Datenleitung zur Übertragung hochfrequenter Datensignale von 10 GBit / sek und mehr geeignet ist und drei elektrische Leiter aufweist,nämlich eine erste Ader, eine zweite Ader und ein Drainwire, wobei die beiden Adern jeweils von einer zylinderförmigen Isolierung umgeben sind und wobei die mindestens eine Datenleitung von einem Schirm, beispielsweise von einer zumindest einseitig elektrisch leitenden Schirmfolie, umgeben ist, und wobei die Anschlussvorrichtung für jeden elektrischen Leiter ein Anschlusspad aufweist.

Dabei sind unter dem Begriff "hochfrequente Digitalsignale" Digitalsignale zu verstehen, deren Bitrate mehr als 10 Gbit / sek., insbesondere sogar 25 Gbit / sek oder mehr beträgt. Derartige Datenleitungen sind unter dem Namen "Twinax" oder "Shielded Twisted Pair" bekannt.

Weiterhin betrifft die Erfindung ein Verfahren zur Verwendung gemäss dem Anspruch 4 einer Anordnung gemäss dem Ansprüchen 1 bis 3.

Eine solche Anschlussvorrichtung, beispielsweise eine Leiterplatte oder ein Steckverbinder, und ein solches Anschlussverfahren werden benötigt, um beim Anschluss einer elektrischen Datenleitung im entsprechenden elektrischen Übergang eine möglichst gute Signalintegrität zu gewährleisten.

### Stand der Technik

Im Stand der Technik ist bereits eine Vielzahl von Lösungen zum Anschluss einer solchen elektrischen Datenleitung bekannt.

Eine Anordung gemäss dem Oberbegriff des Anspruches 1 ist beispielsweise aus dem Dokument US2003/064616 bekannt.

So beschreibt die Druckschrift EP1202419A1 eine entsprechende Anschlussmethode, bei der die Fehlanpassung der differentiellen Impedanz eines Anschlussbereichs des Kabels unter Verwendung eines Schrumpfschlauchs verringert. Dazu wird einem sogenannten "Twisted Pair"-Kabel, dessen beide Leiter im Normalzustand miteinander verdrillt sind, an seinem Anschlussbereich der Schirm entfernt und die beiden Leiter werden mit dazwischen liegendem Drainwire parallel geführt. Durch den Schrumpfschlauch werden gleichbleibende Abstände zwischen den Leitern und dem Drainwire garantiert. Dadurch entsteht im Anschlussbereich eine Twinax-ähnliche Leiterführung. Weiterhin wird offenbart, den Drainwire und das Adernpaar auf unterschiedlichen Seiten der Leiterplatte zu führen und anzuschließen.

Die Druckschrift US6380485B1 beschreibt eine Anschlusseinheit für ein Twinax-Kabel. Dazu wird eine Leiterplatte vorgeschlagen, an welche das Twinax-Kabel angeschlossen wird, und die eine gute Masseverbindung mit dem dazugehörigen Drainwire ermöglicht. Dazu ist der Drainwire rechtwinklig zu den Leitern umgebogen und in eine Ausnehmung der großflächigen Masseschiene eingefügt.

Weiterhin wird in dieser Druckschrift eine Anordnung als bekannter Stand der Technik erwähnt, bei dem eine Vielzahl von Twinax-Kabeln über einen Leiterplattensteckverbinder konventionell an eine Leiterplatte angeschlossen werden. Daraus wird ersichtlich, dass es bekannt ist, die Leiter auf den dazugehörigen Anschlusspads paarweise nebeneinander anzuordnen und durch deren direkt daneben angeschlossenen Drainwire von dem nächsten Leiterpaar zu trennen.

Ein Nachteil im Stand der Technik besteht darin, dass für die immer höheren geforderten Datenraten die Homogenität der Einkopplung im elektrischen Übergang zwischen solchen elektrischen Datenleitung und einer daran angeschlossenen elektrischen Einrichtung, beispielsweise einer Leiterplatte oder einem Steckverbinder, in dem dazugehörigen Anschlussbereich nicht ausreichend ist.

### Aufgabenstellung

Der Erfindung liegt daher die Aufgabe zugrunde, Impedanzunregelmäßigkeiten im Anschlussbereich zu minimieren.

Diese Aufgabe wird mit einer Anschlussvorrichtung der eingangs erwähnten Art dadurch gelöst, dass das zum jeweiligen Drainwire gehörende Anschlusspad zwischen den beiden Anschlusspads der beiden zur selben Datenleitung gehörenden Adern angeordnet ist.

Diese Aufgabe wird weiterhin mit einem Verfahren der eingangs erwähnten Art dadurch gelöst, dass die beiden zu einem Kabel gehörenden Adern mit einem nahezu gleichbleibenden effektiven Abstand bis zu ihren jeweiligen Anschlusspads geführt und dort daran angeschlossen werden.

Dabei bezeichnet der Begriff "effektiver Abstand zueinander" die Summe eines ersten Abstands und eines zweiten Abstands. Der erste Abstand wird dabei zwischen der ersten Ader und dem Drainwire gemessen und der zweite Abstand wird zwischen der zweiten Ader und dem Drainwire gemessen. Dabei macht man sich die Tatsache zunutze, dass die elektrischen Felder der ersten Ader und der zweiten Ader in starkem Maße über den Drainwire in einander einkoppeln.

Unter dem Begriff "nahezu gleichbleibender effektiver Abstand zueinander" ist dementsprechend zu verstehen, dass der Drainwire die beiden zylinderförmigen Isolierungen berührt. Der Begriff "nahezu" wird dabei durch die geometrische Qualität des kreisrunden Querschnitts der zylinderförmigen Isolierung festgelegt.

Vorteilhafte Ausgestaltungen der Erfindung sind in den Unteransprüchen angegeben.

Bei der Erfindung handelt es sich um eine Vorrichtung, die benötigt wird, um die Signalintegrität von hochfrequenten Datenübertragungen zu verbessern.

Ein Vorteil der vorliegenden Erfindung besteht darin, dass sich die Unregelmäßigkeiten der elektrischen Impedanz im Anschlussbereich verringern, wodurch eine gute Einkopplung gegeben ist und hohe Datenraten über diesen Anschluss übertragbar sind.

Ein weiterer Vorteil besteht darin, dass der Anschluss des elektrischen Datenleitung händisch mit vertretbarem Aufwand erfolgen kann.

Beispielsweise kann der Schirm, insbesondere beim Abisolieren, einen Längsschnitt erfahren. Das Kabel wird dann zur Leiterplatte ausgerichtet. Dabei wird durch den Längsschlitz ermöglicht, die Kabel auf die Leiterplattenebene herunterzudrücken, wobei der Drainwire die zylindrischen Isolierungen auseinander schiebt.

Ein entsprechendes Werkzeug kann zum Hinunterdrücken eingesetzt werden. Dieses Werkzeug weist Führungsrippen auf, welche die Isolierungen und damit die elektrischen Leiter führen und ausrichten.

In einer weiteren vorteilhaften Ausführung weist die Anschlusseinrichtung mindestens zwei Gruppen von Anschlusspads auf, die versetzt gegeneinander angeordnet sind. Unter einer "Gruppe von Anschlusspads" sind dabei drei Anschlusspads zu verstehen, die für den Anschluss dreier elektrischer Leiter einer Datenleitung vorgesehen sind. Die Anschlussvorrichtung besitzt in ihrer Anschlussrichtung, d.h. in derjenigen Richtung, aus der die Datenleitungen auf die Anschlusseinrichtung geführt sind, einen geradlinigen Rand. Aus der versetzten Anordnung ergibt sich somit, dass mindestens eine Gruppe von Anschlusspads einen anderen Abstand zu dem geradlinigen Rand besitzt als zumindest eine andere Gruppe von Anschlusspads.

In einer weiteren Ausführungsform weist die Anschlusseinrichtung mehr als zwei Gruppen von Anschlusspads auf. Dann ergibt sich aus der versetzen Anordnung, dass die Anordnung der Gruppen von Anschlusspads auf der Leiterplatte von einer geradlinigen Anordnung abweicht. Dabei bezeichnet der Begriff "geradlinige Anordnung" eine Anordnung, in der die Gruppen von Anschlusspads auf der Leiterplatte in einer Reihe angeordnet sind, d.h. auf einer geraden Linie liegen. Dementsprechend bedeutet das Kennzeichen "dass die Anordnung der Gruppen von Anschlusspads auf der Leiterplatte von einer geradlinigen Anordnung abweicht", dass mindestens eine Gruppe von Anschlusspads nicht auf der geraden Linie liegt, welche durch mindestens zwei andere Gruppen von Anschlusspads verläuft.

Ein Vorteil dieser Ausführung besteht darin, dass das Übersprechen zwischen den verschiedenen Gruppen von Anschlusspads stark reduziert ist.

Ein weiterer zusätzlicher Vorteil dieser Ausführungsform besteht darin, dass gerade bei einer großen Anzahl von Datenleitungen deren Laufzeitunterschiede ausgleichbar sind, weil Wegdifferenzen problemlos ausgeglichen werden können. Dies spielt eine große Rolle, weil gerade im Bereich der hochfrequenten Datenübertragung bereits Kabellängenunterschiede im Millimeterbereich bis hin zum Zentimeterbereich zu relevanten Laufzeitunterschieden führen können, was die Anschlusstechnik üblicherweise erheblich erschwert.

In einer bevorzugten Ausführungsform handelt es sich bei der Anschlussvorrichtung um eine Leiterplatte.

In einer weiteren vorteilhaften Ausgestaltung können die Datenleitungen beispielsweise mit doppeltseitigem Klebeband auf der Anschlusseinrichtung, insbesondere auf einer Leiterplatte, befestigt uns später gemeinsam mit weiteren Komponenten in einem Vergießvorgang mit einer Vergussmasse vergossen zu werden.

In einer bevorzugten Ausführungsform handelt es sich bei der Anschlussvorrichtung um einen Steckverbinder oder zumindest um einen Teil eines Steckverbinders.

### Ausführungsbeispiel

Ein Ausführungsbeispiel der Erfindung ist in der Zeichnung dargestellt und wird im Folgenden näher erläutert. Es zeigen:
Fig. 1 eine Anschlussvorrichtung gemäß dem Stand der Technik mit mehreren daran angeschlossenen elektrischen Datenleitungen in einer schrägen Draufsicht;
Fig. 2 einen Teil der Anschlussvorrichtung gemäß dem Stand der Technik mit einer der daran angeschlossenen elektrischen Datenleitungen in einer Draufsicht;
Fig. 3 eine erfindungsgemäße Anschlussvorrichtung mit der daran angeschlossenen elektrischen Datenleitung in einer schrägen Draufsicht;
Fig. 4 eine erfindungsgemäße Anschlussvorrichtung mit der daran angeschlossenen elektrischen Datenleitung in einer Draufsicht;
Fig. 5 einen Querschnitt durch einen nicht abisolierten Bereich der elektrischen Datenleitung;
Fig. 6 einen Querschnitt durch den Übergang zwischen einem aufgestellten Bereich und einem abisolierten Bereich der elektrischen Datenleitung;
Fig. 7 eine erfindungsgemäße elektrische Einrichtung mit mehreren versetzt angeordneten Gruppen von Anschlusspads.

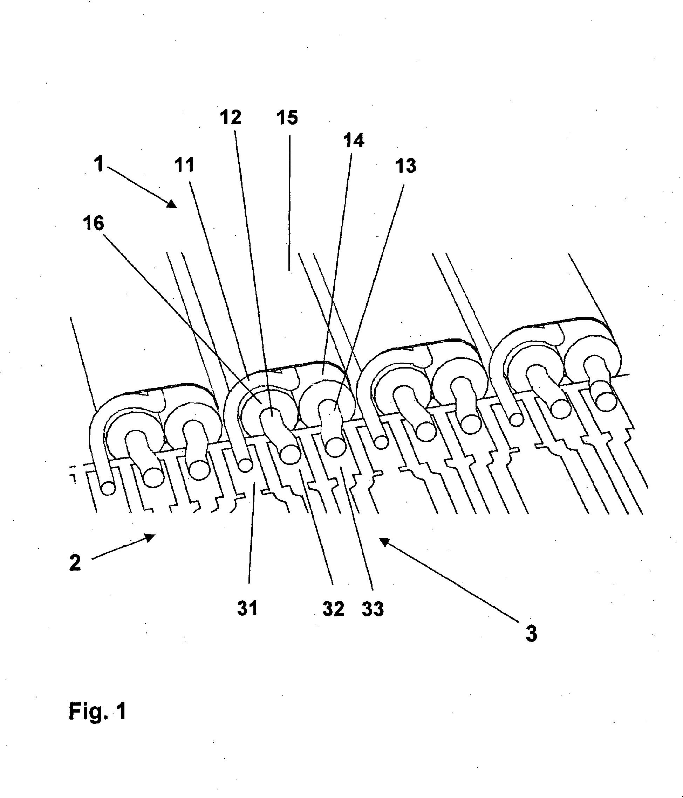

Fig. 1 zeigt eine aus dem Stand der Technik bekannte und üblicherweise verwendete Anordnung. Dabei wird eine Datenleitung 1 neben mehreren gleichen Datenleitungen an eine Anschlusseinrichtung 2 angeschlossen. Die Datenleitung 1 besitzt neben einem Schirm 15 eine erste Ader 12 und eine zweite Ader 13, die jeweils von einer zylindrischen Isolierung 16,14 umgeben sind. Weiterhin besitzt die Datenleitung 1 einen Beilaufdraht ("Drainwire") 11. Die Leiterplatte 2 besitzt für die beiden Adern 12, 13 sowie für den Drainwire 11 der Datenleitung 1 eine Gruppe von Anschlusspads 3, nämlich für den Drainwire 11 ein erstes Anschlusspad 31, für die erste Ader 12 ein zweites Anschlusspad 32 und für die zweite Ader 13 ein drittes Anschlusspad 33. Dabei liegen die Anschlusspads 32, 33 der beiden Adern 12, 13 direkt neben einander. Das Anschlusspad 31 des Drainwires 11 liegt zwischen den Anschlusspads dieses Adernpaars 12, 13 und den Anschlusspads eines Adernpaars einer benachbarten Datenleitung, um dadurch deren elektrische Trennung zu verbessern.

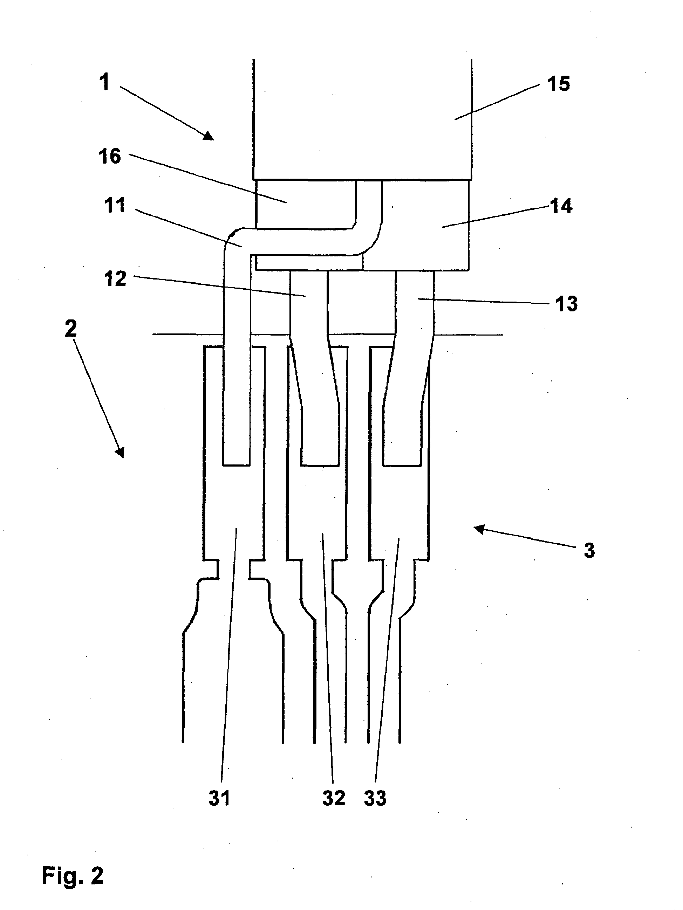

Fig. 2 zeigt dieselbe Anordnung für die einzelne Datenleitung 1 und für die dazugehörige Gruppe von Anschlusspads 3 zur besseren Übersichtlichkeit in einer Draufsicht.

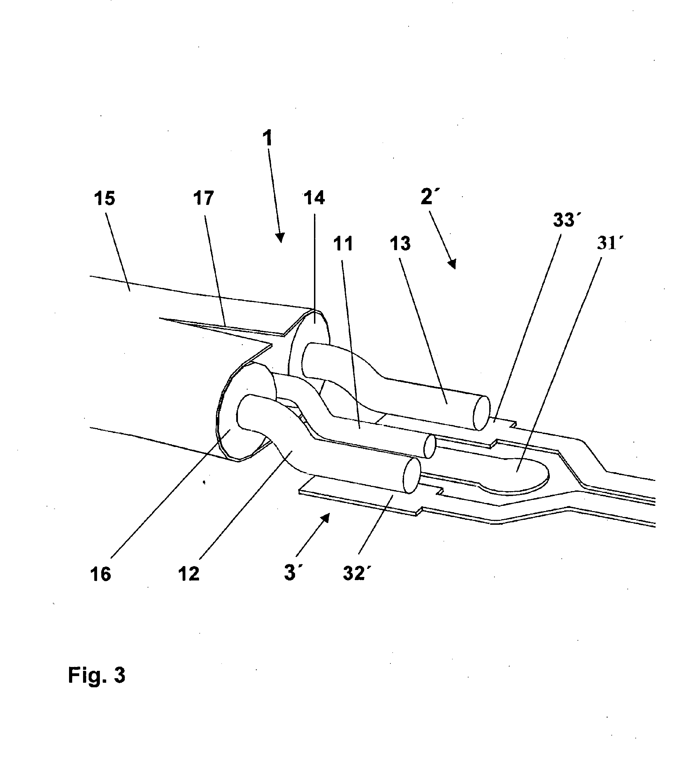

Fig. 3 zeigt eine erfindungsgemäße Anordnung. Dabei ist der Rand der Anschlussvorrichtung 2' nicht graphisch dargestellt. Der Schirm 15 der Datenleitung 1 weist einen Längsschnitt 17 auf. Dadurch wird es ermöglicht, dass die beiden Adern 12, 13 in einem aufgestellten Bereich leicht von einander weggebogen sind. Der Drainwire 11 wird zwischen den beiden Isolierungen 14, 16 hochgeführt und steht dabei im ständigen mechanischen Kontakt mit diesen.

Dementsprechend befindet sich das Anschlusspad 31' des Drainwires 11 zwischen den beiden Anschlusspads 32', 33' des dazugehörigen Adernpaars 12,13.

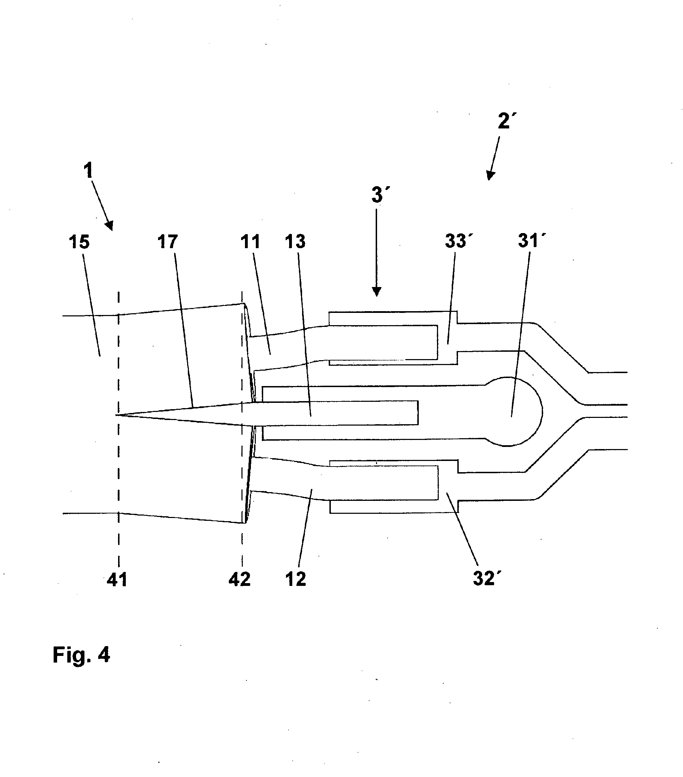

Fig. 4 stellt die vorgenannte Anordnung zur besseren Übersichtlichkeit in einer Draufsicht dar. Dabei ist gut erkennbar, dass sich die beiden Adern 11,12 über die Länge des Schlitzes 17 in dem aufgestellten Bereich voneinander weggebogen sind. Weiterhin ist der Anfang des aufgestellten Bereiches 41 und das Ende des aufgestellten Bereiches 42 gekennzeichnet. Auch in dieser Darstellung ist der Rand der Anschlussvorrichtung 2' nicht graphisch dargestellt.

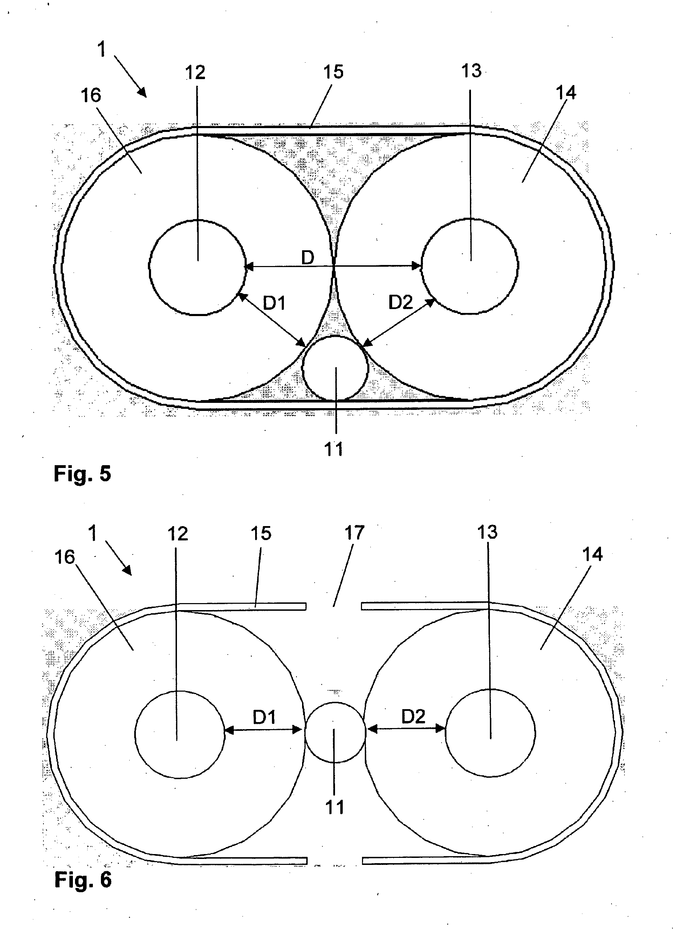

Fig. 5 stellt einen Querschnitt durch die Datenleitung 1 im Normalzustand, also beispielsweise am Anfang 41 des aufgestellten Bereiches dar. Die Isolierungen 14, 16 berühren sich. Die beiden Adern besitzen einen Abstand D zueinander. Die erste Ader 12 besitzt einen Abstand D1 zum Drainwire 11. Die zweite Ader 13 besitzt einen Abstand D2 zum Drainwire 11. Da der Drainwire 11 die beiden zylindrischen Isolierungen 14, 16 berührt, gilt für den effektiven Anstand: D1 + D2 = D.

Fig. 6 stellt einen Querschnitt durch die Datenleitung am Ende 42 des aufgestellten Bereiches dar. Die Adern sind entsprechend dem Schlitz 17 des Schirms weiter von einander entfernt als in der vorgenannten Darstellung. Die Adern 12, 13 koppeln im Wesentlichen über den Drainwire 11 in einander ein. Dadurch bleibt ihr effektiver Abstand erhalten. Obwohl sich der geometrische Abstand D der beiden Adern 12, 13 im Anschlussbereich vergrößert, bleibt der Effektive Abstand D1 + D2 gleich, wodurch sich die Unregelmäßigkeiten der Impedanz im Anschlussbereich verringern.

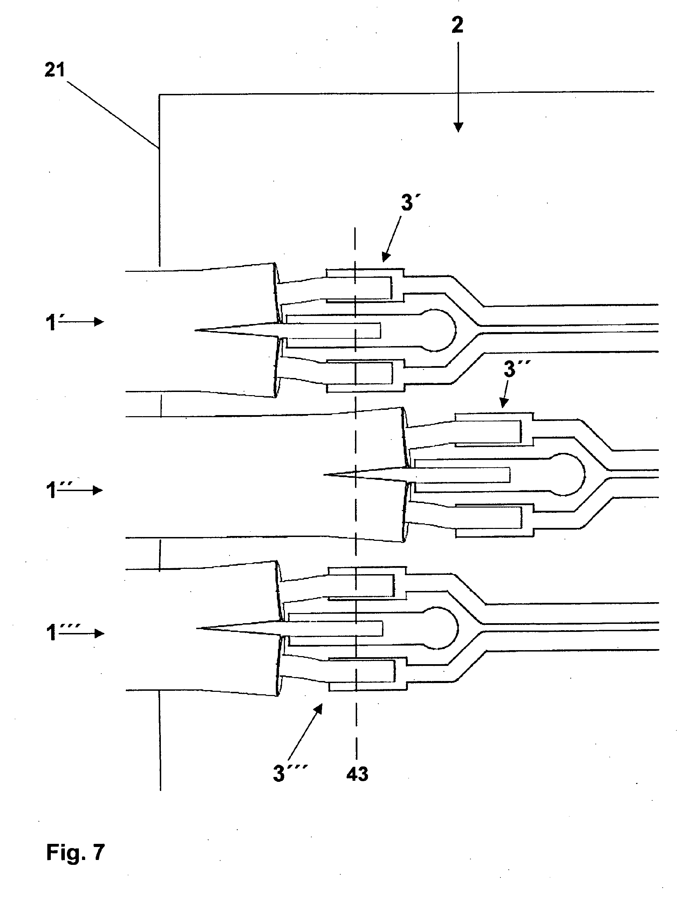

Fig. 7 stellt eine erfindungsgemäße elektrische Einrichtung mit einer ersten Gruppe von Anschlusspads 3', einer zweiten Gruppe von Anschlusspads 3" und einer dritten Gruppe von Anschlusspads 3"' in einer Draufsicht dar. Diese Gruppen von Anschlusspads 3',3" ,3"' besitzen unterschiedliche Abstände zu einem geradlinigen Rand 21 der Leiterplatte 2, d.h. mindestens eine Gruppe 3" besitzt einen anderen Abstand zum geradlinigen Rand 21 als zumindest eine andere Gruppe von Anschlusspads 3',3"'. Betrachten man eine gerade Linie 43, welche durch die erste Gruppe 3' und die dritte Gruppe 3'" verläuft, so ist erkennbar, dass die zweite Gruppe 3" nicht auf dieser Linie 43 liegt.

Aus dieser Darstellung wird ersichtlich, dass ein elektrisches Übersprechen zwischen den verschiedenen Gruppen von Anschlusspads 3',3",3"' durch deren versetzte Anordnung stark reduziert ist, da auf diese Weise die nicht geschirmten Teile einer Datenleitung 1',1"' neben geschirmten Teilen einer anderen Datenleitung 1" zu liegen kommen.

### Bezugszeichenliste

- 1: Datenleitung
- 11: Drainwire
- 12: erste Ader
- 13: zweite Ader
- 14: zylindrische Isolierung der zweiten Ader
- 15: Schirm
- 16: zylindrische Isolierung der ersten Ader
- 17: Längsschlitz

- 2,2': Anschlussvorrichtung
- 21: geradliniger Rand der Anschlussvorrichtung

- 3: Gruppe von Anschlusspads
- 31: Anschlusspad des Drainwires
- 32: Anschlusspad der ersten Ader
- 33: Anschlusspad der zweiten Ader

## Patentansprüche

1. Anordnung, bestehend aus einer Anschlussvorrichtung (2) für hochfrequente Datensignale und mindestens einer zum Anschluss daran vorgesehenden Datenleitung (1), insbesondere einem sogenannten "Twinax"-Kabel, wobei die Datenleitung (1) zur Übertragung hochfrequenter Datensignale von 10 GBit / sek und mehr geeignet ist und drei elektrische Leiter aufweist, nämlich eine erste Ader (12), eine zweite Ader (13) und ein Drainwire (11), wobei die beiden Adern (12,13) jeweils von einer zylinderförmigen Isolierung (14,16) umgeben sind und wobei die mindestens eine Datenleitung (1) von einem Schirm (15), beispielsweise von einer zumindest einseitig elektrisch leitenden Schirmfolie, umgeben ist, und wobei die Anschlussvorrichtung (2) für jeden elektrischen Leiter ein Anschlusspad (31,32,33) aufweist, **dadurch gekennzeichnet,**
**dass** das zum jeweiligen Drainwire (11) gehörende Anschlusspad (31') zwischen den beiden Anschlusspads (32',33') der beiden zur selben Datenleitung (1) gehörenden Adern (12,13) angeordnet ist,
wobei der Schirm (15) der Datenleitung (1) einen Längsschnitt (17) aufweist und wobei die beiden Adern (12,13) in einem aufgestellten Bereich, welcher einen Anfang (41) und eine Ende (42) besitzt, leicht voneinander weggebogen sind und dass der Drainwire (11) in diesem aufgestellten Bereich zwischen den beiden Isolierungen (14, 16) hochgeführt wird und in einem ständigen mechanischen Kontakt mit den dazugehörigen Isolierungen (14,16) steht.

2. Anordnung nach Anspruch 1, **dadurch gekennzeichnet, dass** die Anschlussvorrichtung (2') mindestens zwei Gruppen von Anschlusspads (3',3",3"') aufweist, wobei jede Gruppe von Anschlusspads (3',3",3"') zum Anschluss der elektrischen Leiter (11,12,13) jeweils einer Datenleitung (1',1",1"') vorgesehen ist, wobei die Anschlussvorrichtung (2') in ihrer Anschlussrichtung einen geradlinigen Rand (21) aufweist, und dass mindestens eine Gruppe von Anschlusspads (3',3"') einen anderen Abstand zu dem geradlinigen Rand (21) besitzt als zumindest eine andere Gruppe (3") von Anschlusspads.

3. Anordnung nach Anspruch 1, **dadurch gekennzeichnet, dass** die Anschlussvorrichtung (2') mindestens drei Gruppen von Anschlusspads (3',3",3"') aufweist, wobei jede Gruppe von Anschlusspads (3',3",3"') zum Anschluss der elektrischen Leiter (11,12,13) jeweils einer Datenleitung (1',1",1") vorgesehen ist und dass die Anordnung der Gruppen von Anschlusspads (3',3",3"') auf der Anschlussvorrichtung (2') von einer geradlinigen Anordnung abweicht.

4. Verfahren zur Verwendung einer Anordnung nach einem der Ansprüche 1 bis 3, **dadurch gekennzeichnet,**
**dass** die beiden Adern (12,13) in dem aufgestellten Bereich voneinander weggebogen werden, indem der Drainwire (11) die dazugehörigen Isolierungen auseinander schiebt.

5. Verfahren nach Anspruch 4,
**gekennzeichnet dadurch, dass** die beiden Adern (12,13) im Bereich des Längsschlitzes (17) leicht auseinander gebogen werden.

6. Verfahren nach Anspruch 5,
**dadurch gekennzeichnet, dass** der Drainwire (11) im Bereich des Längsschlitzes (17) zwischen die Isolierungen (14,16) der beiden Adern (12,13) gedrückt wird, und somit für einen nahezu gleichbleibenden effektiven Abstand (D1+D2) zwischen den Adern (12,13) sorgt.

## Claims

1. An arrangement, consisting of a connection device (2) for high-frequency data signals and at least one data line (1), in particular a so-called "twinax" cable, provided for connection thereto, the data line (1) being suitable for transmitting high-frequency data signals of 10 GBit/sec. and more and including three electrical conductors, namely a first wire (12), a second wire (13), and a drain wire (11), each of the two wires (12, 13) being surrounded by a cylindrical insulation (14, 16), and the at least one data line (1) being surrounded by a shield (15), for example by a shielding foil that is electrically conductive on at least one side, and the connection device (2) including a connecting pad (31, 32, 33) for each electrical conductor, **characterized in that**
the connecting pad (31') associated with the respective drain wire (11) is arranged between the two connecting pads (32', 33') of the two wires (12, 13) associated with the same data line (1), the shield (15) of the data line (1) having a longitudinal cut (17), and
the two wires (12, 13) being bent slightly away from each other in a vee-bent portion which has a beginning (41) and an end (42), and **in that** in this vee-bent portion the drain wire (11) is guided up between the two insulations (14, 16) and is in a constant mechanical contact with the associated insulations (14, 16).

2. The arrangement according to claim 1, **characterized in that** the connection device (2') includes at least two groups of connecting pads (3', 3", 3'"), each group of connecting pads (3', 3", 3"') being provided for connection of the electrical conductors (11, 12, 13) of one data line (1', 1", 1'") each, the connection device (2') including a straight-line edge (21) in its direction of connection, and **in that** at least one group of connecting pads (3', 3'") has a different distance from the straight-line edge (21) than at least one other group (3") of connecting pads.

3. The arrangement according to claim 1, **characterized in that** the connection device (2') includes at least three groups of connecting pads (3', 3", 3"'), each group of connecting pads (3', 3", 3"') being provided for connection of the electrical conductors (11, 12, 13) of one data line (1', 1", 1'") each, and **in that** the arrangement of the groups of connecting pads (3', 3", 3"') on the connection device (2') deviates from a straight-line arrangement.

4. A method of using an arrangement according to any of claims 1 to 3, **characterized in that**
the two wires (12, 13) in the vee-bent portion are bent away from each other by the drain wire (11) pushing the associated insulations apart.

5. The method according to claim 4, **characterized in that**
the two wires (12, 13) are bent slightly apart in the region of the longitudinal slit (17).

6. The method according to claim 5, **characterized in that**
the drain wire (11) is pressed between the insulations (14, 16) of the two wires (12, 13) in the region of the longitudinal slit (17) and thus provides for a practically constant effective distance (D1+D2) between the wires (12, 13).

## Revendications

1. Agencement, composé d'un dispositif de raccordement (2) pour des signaux de données à haute fréquence et d'au moins une ligne de données (1) prévue pour le raccordement sur celui-ci, en particulier un câble dit « Twinax », la ligne de données (1) étant adaptée à la transmission de signaux de données à haute fréquence de 10 Gbit/s et plus et présentant trois conducteurs électriques, à savoir un premier brin (12), un deuxième brin (13) et un fil drain (11), les deux brins (12, 13) étant chacun entourés d'une isolation cylindrique (14, 16), et ladite au moins une ligne de données (1) étant entourée d'un blindage (15), par exemple d'une feuille de blindage électriquement conductrice au moins d'un côté, et le dispositif de raccordement (2) présentant pour chaque conducteur électrique un plot de raccordement (31, 32, 33), **caractérisé en ce que**
le plot de raccordement (31') associé au fil drain (11) respectif est agencé entre les deux plots de raccordement (32', 33') des deux brins (12, 13) appartenant à la même ligne de données (1), le blindage (15) de la ligne de données (1) présentant une section longitudinale (17), et
les deux brins (12, 13) étant légèrement repliés en éloignement l'un de l'autre dans une zone redressée qui présente un début (41) et une fin (42), et **en ce que** dans cette zone redressée, le fil drain (11) est guidé vers le haut entre les deux isolations (14, 16) et est constamment en contact mécanique avec les isolations associées (14, 16).

2. Agencement selon la revendication 1, **caractérisé en ce que** le dispositif de raccordement (2') présente au moins deux groupes de plots de raccordement (3', 3", 3"'), chaque groupe de plots de raccordement (3', 3", 3"') étant prévu pour le raccordement des conducteurs électriques (11, 12, 13) d'une ligne de données respective (1', 1 ", 1'"), le dispositif de raccordement (2') présentant dans son sens de raccordement un bord rectiligne (21), et **en ce qu'**au moins un groupe de plots de raccordement (3', 3"') présente une autre distance du bord rectiligne (21) qu'au moins un autre groupe (3") de plots de raccordement.

3. Agencement selon la revendication 1, **caractérisé en ce que** le dispositif de raccordement (2') présente au moins trois groupes de plots de raccordement (3', 3", 3"'), chaque groupe de plots de raccordement (3', 3", 3"') étant prévu pour le raccordement des conducteurs électriques (11, 12, 13) d'une ligne de données respective (1', 1", 1 "'), et **en ce que** l'agencement des groupes de plots de raccordement (3', 3", 3"') sur le dispositif de raccordement (2') diffère d'un agencement rectiligne.

4. Procédé d'utilisation d'un agencement selon l'une des revendications 1 à 3, **caractérisé en ce que** les deux brins (12, 13) sont repliés en éloignement l'un de l'autre dans la zone redressée **en ce que** le fil drain (11) écarte les isolations associées l'une de l'autre.

5. Procédé selon la revendication 4, **caractérisé en ce que** les deux brins (12, 13) sont légèrement repliés en éloignement l'un de l'autre dans la zone de la fente longitudinale (17).

6. Procédé selon la revendication 5, **caractérisé en ce que** dans la zone de la fente longitudinale (17), le fil drain (11) est pressé entre les isolations (14, 16) des deux brins (12, 13) et assure ainsi une distance effective (D1 + D2) pratiquement constante entre les brins (12, 13).
